# EUROPÄISCHE PATENTSCHRIFT

(11) **EP 2 155 526 B1**
(45) Veröffentlichungstag und Bekanntmachung des Hinweises auf die Patenterteilung: **29.09.2010**
(21) Anmeldenummer: 08758666.5
(22) Anmeldetag: 21.05.2008
(51) Int. Cl.: B60T 8/36, H01F 7/18, H03K 17/16

(54) **ANORDNUNG ZUM SCHALTEN VON VENTILEN IN ACHSMODULEN EINES NUTZFAHRZEUGS**
ARRANGEMENT FOR SWITCHING VALVES IN AXLE MODULES OF A UTILITY VEHICLE
MONTAGE POUR LA COMMUTATION DE SOUPAPES DANS DES MODULES AXIAUX D'UN VÉHICULE UTILITAIRE

(30) Priorität: 31.05.2007 DE 102007025430
(43) Veröffentlichungstag der Anmeldung: 24.02.2010
(73) Patentinhaber: KNORR-BREMSE Systeme für Nutzfahrzeuge GmbH, 80809 München (DE)
(72) Erfinder: FEUCHT, Thomas, 71299 Wimsheim (DE)
(74) Vertreter: Schönmann, Kurt
(86) Internationale Anmeldenummer: PCT/EP2008/004060
(87) Internationale Veröffentlichungsnummer: WO 2008/145288

(56) Entgegenhaltungen:
- EP-A- 1 422 815
- WO-A-2008/071713
- DE-A1- 4 205 563
- DE-B4-102004 007 209
- DE-C1- 19 632 365
- US-A- 5 752 482

## Beschreibung

Die Erfindung betrifft eine Schaltungsanordnung zum Schalten von Ventilen in Achsmodulen eines Nutzfahrzeugs, und bezieht sich insbesondere auf eine rationelle Schaltungsanordnung zum Schalten zweier Backup-Ventile in einem Hinterachsmodul eines elektronischen Bremssystems eines Nutzfahrzeugs mit einem redundanten pneumatischen Bremssystem.

Zusätzlich zu einem elektronischen Bremssystem (EBS) besitzen Nutzfahrzeuge aus Sicherheitsgründen zusätzlich noch ein pneumatisches Bremssystem, welches eine Redundanzfunktion bereitstellt und zum Einsatz kommt, falls beispielsweise das elektronische Bremssystem versagt. Hierzu sind an Radmodulen eines Nutzfahrzeugs so genannte Backup-Ventile angeordnet, die im fehlerfreien Normalbetrieb mit dem von dem Fahrer des Nutzfahrzeugs angeforderten Steuerdruck aus der Druckluftanlage des Nutzfahrzeugs bestromt werden, selbst aber geschlossen bleiben. Bei einem Ausfall des elektronischen Bremssystems wird das Backup-Ventil geöffnet und steuert den an ihm anliegenden Bremsdruck ein, während das reguläre Einlass- und das Auslassventil geschlossen werden.

Derartige Backup-Ventile sind in der Regel als an sich bekannte Magnetventile ausgeführt und werden in Fahrzeugen, etwa Nutzfahrzeugen, bevorzugt zur Umsetzung von elektrischen Steuerimpulsen in unter anderem hydraulische oder pneumatische Steuerimpulse zur Steuerung von zum Beispiel automatisch bzw. elektronisch gesteuerten Getrieben oder elektronischen Bremssystemen verwendet.

Bekannt sind in diesem Zusammenhang Hinterachsmodule in elektronischen Bremssystemen, über welche eine Ansteuerung von zwei Backup-Ventilen mittels einem Steuergerät durch Pulsweitenmodulation erfolgt.

Sind mehrere Ventile vorhanden, üblicherweise eines an jedem Radmodul des Nutzfahrzeugs, werden bislang entsprechend der Anzahl der Backup-Ventile mehrere Ansteuereinrichtungen, wie beispielsweise je eine separate Ventilendstufe für jedes anzusteuernde Backup-Ventil, für eine unabhängige Ansteuerung derselben verwendet.

Nachteilig resultieren somit ein erhöhter Aufwand an Bauteilen sowie eine komplexere Ansteuerung, die insbesondere auf dem Fahrzeugsektor in unerwünscht hohen Kosten und einem höherem Entwicklungsaufwand resultieren. Zudem birgt eine höhere Anzahl von Bauteilen im Gesamtsystem ein höheres Ausfallrisiko und kann dadurch zu einer verschlechterten Wirtschaftlichkeit des Fahrzeugs führen.

Bekannt sind darüber hinaus aus der Druckschrift US-A-5 752 482 ein Lasttreibersystem zum integralen Steuerns eines Stromflusses durch eine Anzahl von induktiven Lasten einer Brennkraftmaschine wie einer Einspritzdüsenspule und einer Motorbremsspule während des Betriebs eines Motorzylinders, aus der Druckschrift DE 196 32 365 C1 eine Schaltungsanordnung zum voneinander unabhängigen Schalten mehrerer, paralleler Induktivitäten, aus der Druckschrift EP-A-1 422 815 ein Verfahren und eine Vorrichtung zur Ansteuerung eines elektrischen Verbrauchers, bei der ein Energiespeicher beim Öffnen eines Schalters die Energie eines induktiven Elements aufnimmt, aus der Druckschrift DE 42 05 563 A1 eine Elektromagnetspule für Ventile mit einer Nebenspule parallel zu einem temperaturabhängigen Widerstand, und aus der Druckschrift DE 10 2004 007209 B4 eine Schaltungsanordnung und ein Verfahren zur Ermittlung des laststroms durch eine getaktet an eine Versorgungsspannung angelegte induktive Last.

Der Erfindung liegt daher als eine Aufgabe zugrunde, eine verbesserte Schaltungsanordnung zum Schalten von Backup-Ventilen in Hinterachsmodulen von Nutzfahrzeugen zu schaffen, die zur Ansteuerung der Backup-Ventile eine verringerte Zahl von Bauelementen erfordert und mithin kostengünstiger herzustellen ist.

Erfindungsgemäß wird diese Aufgabe durch die Merkmale des Patentanspruchs 1, und alternativ durch die Merkmale des nebengeordneten Patentanspruchs 4 gelöst.

Vorteilhafte Weiterbildungen der Erfindung sind Gegenstand der beigefügten Unteransprüche.

Nachstehend werden bevorzugte Ausführungsbeispiele der Erfindung unter Bezugnahme auf die beigefügte Zeichnung beschrieben. Es zeigen:
Fig. 1 stark vereinfacht eine prinzipielle Schaltungsanordnung zum Schalten von Backup-Ventilen in Hinterachsmodulen eines Nutzfahrzeugs gemäß einem ersten Ausführungsbeispiel; und
Fig. 2 stark vereinfacht eine alternative, prinzipielle Schaltungsanordnung zum Schalten von Backup-Ventilen in Hinterachsmodulen gemäß einem zweiten Ausführungsbeispiel.

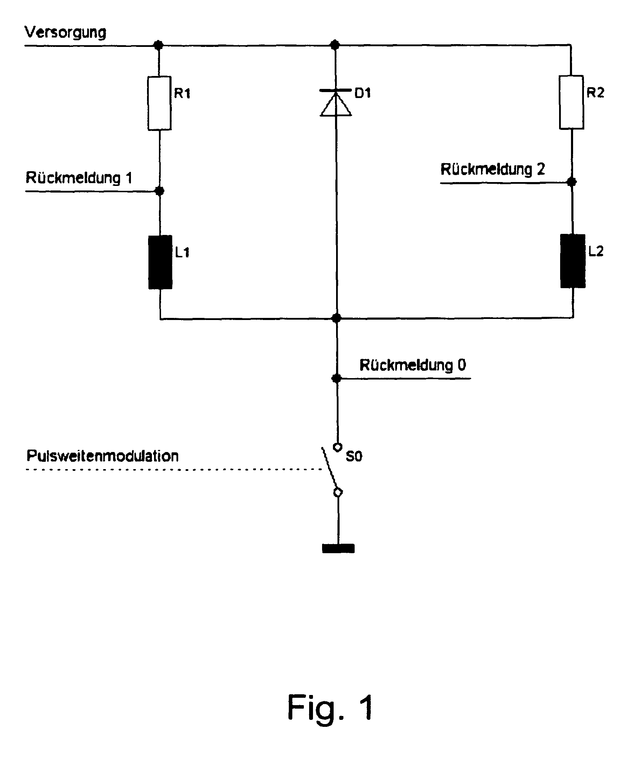

Die in Fig. 1 dargestellte Schaltungsanordnung ist für beliebige Magnetventile in Anwendungen geeignet, in welchen Magnete gleichzeitig zu schalten sind, und findet bevorzugt bei elektronischen Bremssystemen Anwendung, ist jedoch nicht hierauf beschränkt.

Wie der vereinfachten Schaltungsanordnung gemäß Fig. 1 entnehmbar ist, umfasst die vorgeschlagene, rationelle, Lösung gemäß dem ersten Ausführungsbeispiel einen Schalter S0, welcher bevorzugt ein Feldeffekttransistor ist, eine Pulsweitenmodulationsleitung, über welche eine Pulsweitenmodulation für alle Backup-Ventile an dem Schalter S0 eingesteuert wird, eine Diode D1, welche zur langsamen Löschung der Backup-Ventile dient, eine Spannungsrückmeldung (Rückmeldung 0), Widerstände R1 und R2 für eine Stromrückmeldung (Rückmeldungen 1 bis 2) durch Ausleiten eines Stroms an eine (nicht gezeigte) Steuereinrichtung, Induktivitäten L1 und L2, welche die Spulen der beiden Backup-Ventile repräsentieren, eine Versorgungsleitung (Versorgung) zur Spannungsversorgung der Schaltungsanordnung und einen Masseanschluss.

Im Einzelnen sind der Schalter S0 und die Diode D1 in einem ersten Zweig der Schaltungsanordnung in einer Reihenverschaltung verbunden. Parallel zu der Diode D1 in dem ersten Zweig sind jeweils eine Reihenverschaltung (R1/L1, R2/L2) für je eines der Backup-Ventile ausgebildet, wobei an je einem Schaltungsknoten zwischen dem Widerstand R1 und der Induktivität L1 sowie zwischen dem Widerstand R2 und der Induktivität L2 je eine Stromrückmeldung ausgeleitet wird. Jeweils ein Anschluss der Widerstände R1, R2 und der Diode D1 ist mit dem Potenzial der Versorgungsspannung verbunden, während jeweils ein Anschluss der Induktivitäten L1, L2 und der andere Anschluss der Diode D1 an einem gemeinsamen Schaltungsknoten mit einem Anschluss des Schalters S0 und der Rückmeldeleitung 0 verbunden ist.

Der andere Anschluss des Schalters S0 liegt auf einem Massepotenzial des Masseanschlusses, so dass die Parallelschaltung des seriellen Schaltungszweigs aus Induktivität L1 und Widerstand R1, der Diode D1, und des seriellen Schaltungszweigs aus Induktivität L2 und Widerstand R2 über den Schalter S0 mit dem Massepotenzial verbindbar ist.

Mit der in Fig. 1 gezeigten Schaltungsanordnung lässt sich auf vorteilhafte Art und Weise die Anzahl der erforderlichen Bauelemente verringern, da bei der Ansteuerung beider Backup-Ventile über das Hinterachsmodul des Nutzfahrzeugs grundsätzlich immer beide Backup-Ventile gemeinsam geschaltet werden.

Die Backup-Ventile können hierbei sowohl parallel wie auch in Reihe geschaltet sein, ohne dass sich die Schaltzeiten der Ventile ändern. In anderen Worten kann unabhängig von der Art der Verschaltung eine Auslegung der Schaltungsanordnung ohne Rücksicht auf eine Änderung der Schaltzeiten durchgeführt werden, so dass sich hierdurch eine Änderung der Reaktionszeit der Bremsanlage bei Ausfall des elektronischen Bremssystems nicht ändert und sich somit eine dadurch mögliche, sicherheitsrelevante Auswirkung nicht ergibt.

Es wird angemerkt, dass die Rückmeldeleitungen R0 bis R2 zu der (nicht gezeigten) Steuereinrichtung eine Erfassung eines Fehlerzustands ermöglichen, wobei die Rückmeldeleitung R0 aufgrund des durch die Pulsweitenmodulation erzeugten mittleren Potentials ferner eine virtuelle Masse darstellt und somit eine konstante Spannung über den einzelnen Spulen/Induktivitäten L1, L2 der Magnetventile gewährleistet.

Es wird ferner angemerkt, dass die Induktivitäten L1, L2 der Magnetventile sowohl extern als auch, beispielsweise bei elektronischen Bremssystemen, intern im Magnetventilkörper angeordnet sein können.

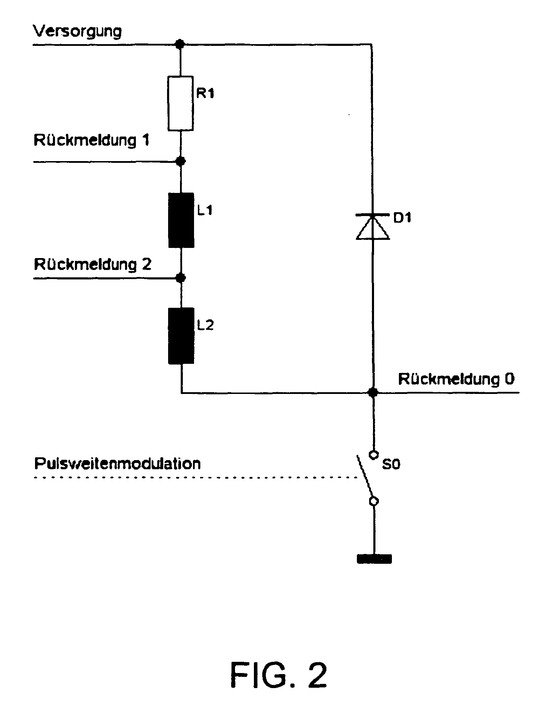

Eine Reihenschaltung wie vorstehend erwähnt ist in Fig. 2 als alternatives Ausführungsbeispiel dargestellt. Hierbei bezeichnen gleiche Bezugszeichen gleiche Elemente wie in Fig. 1, so dass eine erneute Beschreibung solcher Elemente weggelassen wird.

Die in Fig. 2 dargestellte Schaltungsanordnung ist ebenfalls für beliebige Magnetventile in Anwendungen geeignet, in welchen Magnete gleichzeitig zu schalten sind, und findet bevorzugt bei elektronischen Bremssystemen Anwendung, ohne hierauf beschränkt zu sein.

Wie Fig. 2 entnehmbar ist, ist eine Reihenschaltung aus einem Widerstand R1, einer Induktivität L1 und einer Induktivität L2 parallel zu der Diode D1 verschaltet. Mit anderen Worten wurde einer von zwei in Fig. 1 parallel zu der Diode D1 liegenden Zweigen, bestehend aus je einer Reihenschaltung aus einer Induktivität und einem Widerstand, durch einen einzigen zu der Diode D1 parallel verschalteten Zweig, bestehend aus einem Widerstand R1 und den zwei die Spulen der beiden Backup-Ventile repräsentierenden Induktivitäten L1, L2 ersetzt.

Es wird angemerkt, dass auch in diesem Ausführungsbeispiel der Widerstand R1 zur Erzeugung einer Stromrückmeldung an eine Steuereinrichtung dient, die einzelnen Rückmeldungen 1 und 2 jedoch einerseits an einem Schaltungsknoten zwischen dem Widerstand R1 und der Induktivität L1 des einen der beiden Backup-Ventile (Rückmeldung 1) und andererseits an einem Schaltungsknoten zwischen der Induktivität L1 des einen der beiden Backup-Ventile und der Induktivität L2 des anderen der beiden Backup-Ventile (Rückmeldung 2) ausgeleitet wird.

Die verbleibende Anordnung der in Fig. 2 gezeigten alternativen Lösung entspricht der des ersten Ausführungsbeispiels gemäß Fig. 1.

In Übereinstimmung mit der vorangehenden Beschreibung zweier bevorzugter Ausführungsbeispiels stellt die Erfindung die nachstehenden Lösungen und Abhilfen für bekannte Anordnungen bereit.

Das in Fig. 1 gezeigte erste Ausführungsbeispiel und das in Fig. 2 gezeigte zweite Ausführungsbeispiel weisen gegenüber den bisher bekannten Lösungen deutliche Vorteile dahin gehend auf, dass nur eine Löschdiode D1 für zwei Backup-Ventile mit den Induktivitäten L1, L2 benötigt wird, und dass nur ein schneller Schalter S0 zur Erzeugung der Pulsweitenmodulation notwendig ist.

Darüber hinaus wird bei dem in Fig. 2 gezeigten Ausführungsbeispiel gegenüber demjenigen der Fig. 1 durch den Entfall auch des Widerstands R2 vorteilhaft eine nochmals bessere Verringerung der erforderlichen Anzahl von Bauteilen erreicht.

Insgesamt wird durch die vorgeschlagene Schaltungsanordnung eine wesentliche Verringerung des Aufwands an Bauelementen und Bauteilen dadurch erreicht, dass mehrere zu schaltende Magnetventile zusammengefasst werden. Hierbei ist die Schaltungsanordnung nicht auf eine bestimmte Art von Ventilen beschränkt, sondern kann für beliebige, elektrisch oder elektronisch zu schaltende Ventile Anwendung finden.

Strukturelle Implementationen, die zu der detaillierten Beschreibung der bevorzugten Ausführungsbeispiele ähnlich sind, sind für den Fachmann ohne Weiteres zu erkennen und nicht als Abweichen von dem Gegenstand der Erfindung wie in den nachfolgenden Patentansprüchen definiert zu werten.

Es wurde somit eine Schaltungsanordnung zum Schalten zweier Backup-Ventile in einem Hinterachsmodul eines elektronischen Bremssystems eines Nutzfahrzeugs beschrieben, umfassend: einen Schalter S0, an dem eine Pulsweitenmodulation zur Steuerung von Magnetfeldern von Induktivitäten L1, L2 der beiden Backup-Ventile eingesteuert wird; und eine Diode D1 für eine langsame Löschung der beiden Backup-Ventile in Übereinstimmung mit einem vorbestimmten Betriebszustand der beiden Backup-Ventile; wobei die Diode D1 parallel zu zwei jeweils eine Induktivität L1, L2 der beiden Backup-Ventile enthaltenden Zweigen der Schaltungsanordnung verschaltet ist und die beiden Backup-Ventile in Übereinstimmung mit dem vorbestimmten Betriebszustand gleichzeitig schaltet. In einer alternativen Ausführungsform sind in nur einem zu der Diode D1 parallel verschalteten Zweig die Induktivitäten L1, L2 in Reihe verschaltet.

### Bezugszeichenliste

- Versorgung Rückmeldungen 0 bis 2: gemeinsame Versorgungsleitung Rückmeldeleitungen
- S0: Schalter
- L1, L2: Induktivitäten
- R1, R2: Widerstände
- D1: Diode
- Pulsweitenmodulation: Pulsweitenmodulations- Einsteuerleitung

## Patentansprüche

1. Schaltungsanordnung zum Schalten zweier Backup-Ventile in einem Hinterachsmodul eines elektronischen Bremssystems eines Nutzfahrzeugs mit einem redundanten pneumatischen Bremssystem, mit:
- einem ersten Backup-Magnetventil in dem redundanten pneumatischen Bremssystem mit einer ersten Induktivität (L1) in einem ersten Schaltungsteilzweig der Schaltungsanordnung;
- einem zweiten Backup-Magnetventil in dem redundanten pneumatischen Bremssystem mit einer zweiten Induktivität (L2) in einem zweiten Schaltungsteilzweig der Schaltungsanordnung:
- einer Löschdiode (D1) für das erste und das zweite Backup-Magnetventil in einem dritten Schaltungsteilzweig der Schaltungsanordnung für eine langsame Löschung des ersten und des zweiten Backup-Magnetventils dann, wenn das erste und das zweite Backup-Magnetventil in einer Redundanzbetriebsart bei Ausfall des elektronischen Bremssystems zur Einsteuerung eines pneumatischen Bremsdrucks geöffnet werden; und
- einem Schalter (S0) in einem vierten Schaltungsteilzweig der Schaltungsanordnung, durch welchen eine Pulsweitenmodulation zur Steuerung der Magnetfelder der ersten und der zweiten Induktivität (L1, L2) des ersten und des zweiten Backup-Magnetventils eingesteuert wird;
- wobei die erste und die zweite Induktivität (L1, L2) in dem ersten und dem zweiten Schaltungsteilzweig der Schaltungsanordnung und die Löschdiode (D1) in dem dritten Schaltungsteilzweig der Schaltungsanordnung parallel zueinander verschaltet sind;
- die erste und die zweite Induktivität (L1, L2) über einen ersten und einen zweiten Widerstand (R1, R2) in dem ersten und dem zweiten Schaltungsteilzweig der Schaltungsanordnung und die Löschdiode (D1) in dem dritten Schaltungsteilzweig der Schaltungsanordnung an einem ersten gemeinsamen Schaltungsknotenpunkt an einer Versorgungsspannung der Schaltungsanordnung liegen und die erste und die zweite Induktivität (L1, L2) und die Löschdiode (D1) an einem zweiten gemeinsamen schaltungsknotenpunkt auf einem Zwischenpotenzial zwischen der Versorgungsspannung und einem Massepotential der Schaltungsanordnung mit einem ersten Anschluss des Schalters (S0) verbunden sind;
- die Kathode der Löschdiode (D1) mit der Versorgungsspannung und die Anode der Löschdiode (D1) mit dem Zwischenpotenzial verbunden sind; und
- der Schalter (SO) in dem vierten Schaltungsteilzweig in Reihe mit der Parallelschaltung des ersten, des zweiten und des dritten Schaltungsteilzweigs zwischen dem Zwischenpotenzial und dem Massepotenzial verschaltet ist und die beiden Backup-Magnetventile in der Redundanzbetriebsart gleichzeitig schaltet.

2. Schaltungsanordnung nach Anspruch 1, wobei der erste, die erste Induktivität (L1) enthaltende Schaltungsteilzweig den ersten Widerstand (R1) enthält, der mit der ersten Induktivität (L1) eine erste Reihenschaltung (L1/R1) in dem ersten Schaltungsteilzweig bildet, und der zweite, die zweite Induktivität (L2) enthaltende Schaltungsteilzweig den zweiten Widerstand (R2) enthält, der mit der zweiten Induktivität (L2) eine zweite Reihenschaltung (L2/R2) in dem zweiten Schaltungsteilzweig bilde.

3. Schaltungsanordnung nach Anspruch 2, wobei in der ersten Reihenschaltung (L1/R1) zwischen der ersten Induktivität (L1) und dem ersten Widerstand (R1) und in der zweiten Reihenschaltung (L2/R2) zwischen der zweiten Induktivität (L2) und dem zweiten Widerstand (R2) jeweils eine Rückmeldeleitung zur Rückmeldung eines Zustands der Schaltungsanordnung vorgesehen ist, und eine Steuereinrichtung anhand des zurückgemeldeten Zustands einen Fehlerzustand der Schaltungsanordnung erfasst.

4. Schaltungsanordnung zum Schalten zweier Backup-Ventile in einem Hinterachsmodul eines elektronischen Bremssystems eines Nutzfahrzeugs mit einem redundanten pneumatischen Bremssysten, mit:
- einem ersten Backup-Magnetventil in dem redundanten pneumatischen Bremssystem mit einer ersten Induktivität (L1) in einem ersten Schaltungsteilzweig der Schaltungsanordnung;
- einem zweiten Backup-Magnetventil in dem redundanten pneumatischen Bremssystem mit einer zweiten Induktivität (L2) in dem ersten Schaltungsteilzweig der Schaltungsanordnung:
- einer Löschdiode (D1) für das erste und das zweite Backup-Magnetventil in einem zweiten Schaltungsteilzweig der Schaltungsanordnung für eine langsame Löschung des ersten und des zweiten Backup-Magnetventils dann, wenn das erste und das zweite Backup-Magnetventil in einer Redundanzbetriebsart bei Ausfall des elektronischen Bremssystems zur Einsteuerung eines pneumatischen Bremsdrucks geöffnet werden; und
- einem Schalter (S0) in einem dritten Schaltungsteilzweig der Schaltungsanordnung, durch welchen eine Pulsweitenmodulation zur Steuerung der Magnetfelder der ersten und der zweiten Induktivität (L1, L2) des ersten und des zweiten Backup-Magnetventils eingesteuert wird;
- wobei die erste und die zweite Induktivität (L1, L2) in dem ersten. Schaltungsteilzweig der Schaltungsanordnung in Reihe miteinander verschaltet sind und die Löschdiode (D1) in dem zweiten Schaltungsteilzweig der Schaltungsanordnung parallel zu der Reihenschaltung der ersten und der zweiten Induktivität (L1, L2) in dem ersten Schaltungsteilzweig der Schaltungsanordnung verschaltet ist;
- die erste Induktivität (L1) über einen Widerstand (R1) in dem ersten Schaltungsteilzweig der Schaltungsanordnung und die Löschdiode (D1) in dem zweiten Schaltungsteilzweig der Schaltungsanordung an einem ersten gemeinsamen Schaltungsknotenpunkt an einer Versorgungsspannung der Schaltungsanordnung liegen und die zweite Induktivität (L2) und die Löschdiode (D1) an einem zweiten gemeinsamen Schaltungsknotenpunkt auf einem Zwischenpotenzial zwischen der Versorgungsspannung und einem Massepotenzial der Schaltungsanordnung mit einem ersten Anschluss des Schalters (SO) verbunden sind;
- die Kathode der Löschdiode (D1) mit der Versorgungsspannung und die Anode der Löschdiode (D1) mit dem Zwischenpotenzial verbunden sind; und
- der Schalter (S0) in dem dritten Schaltungsteilzweig in Reihe mit der Parallelschaltung des ersten und des zweiten Schaltungsteilzweigs zwischen dem Zwischenpotenzial und dem Massepotenzial verschaltet ist und die beiden Backup-Magnetventile in der Redundanzbetriebsart gleichzeitig schaltet.

5. Schaltungsanordnung nach Anspruch 4, wobei der die Reihenschaltung der ersten und der zweiten Induktivität (L1, L2) der beiden Backup-Magnetventile enthaltende erste Schaltungsteilzweig den Widerstand (R1) enthält, der mit der Reihenschaltung der ersten und der zweiten Induktivität (L1, L2) wiederum eine Reihenschaltung (R1, L1, L2) bildet.

6. Schaltungsanordnung nach Anspruch 5, wobei zwischen der ersten Induktivität (L1) und der zweiten Induktivität (L2) in dem ersten parallelen Schaltungsteilzweig und zwischen der ersten Induktivität (L1) und dem Widerstand (R1) in dem ersten parallelen Schaltungsteilzweig jeweils eine Rückmeldeleitung zur Rückmeldung eines Zustands der Schaltungsanordnung vorgesehen ist, und eine Steuereinrichtung anhand des zurückgemeldeten Zustands einen Fehlerzustand der Schaltungsanordnung erfasst.

7. Schaltungsanordnung nach einem der vorangehenden Ansprüche, wobei die Ansteuerung des Schalters (S0) zur Erzeugung der gemeinsamen Pulsweitenmodulation über eine Pulsweitenmodulations-Einsteuerleitung erfolgt.

8. Schaltungsanordnung nach einem der vorangehenden Ansprüche, wobei der Schalter (SO) ein schnell schaltender Feldeffekt-Transistor ist.

9. Schaltungsanordnung nach einem der vorangehenden Ansprüche, wobei ein Anschluss des Schalters (SO) mit dem Massepotenzial verbunden ist.

10. Schaltungsanordnung nach einem der vorangehenden Ansprüche, wobei die an dem ersten Schalter (S0) eingesteuerte Pulsweitenmodulation die Schaltungsanordnung mit einer Frequenz zwischen 1 und 10 kHz taktet.

## Claims

1. A circuit arrangement for switching two backup valves in a rear axle module of an electronic brake system of a utility vehicle with a redundant pneumatic brake system, having:
- a first backup solenoid valve in the redundant pneumatic brake system having a first inductor (L1) in a first circuit component branch of the circuit arrangement;
- a second backup solenoid valve in the redundant pneumatic brake system having a second inductor (L2) in a second circuit component branch of the circuit arrangement;
- an extinguishing diode (D1) for the first and second backup solenoid valves in a third circuit component branch of the circuit arrangement for a slow discharge of the first and second backup solenoid valves when the first and second backup solenoid valves are opened in a redundant operating mode in order to apply a pneumatic brake pressure when the electronic brake system fails; and
- a switch (SO) in a fourth circuit component branch of the circuit arrangement, by means of which switch (SO) pulse width modulation for controlling the magnetic fields of the first and second inductors (L1, L2) of the first and second backup solenoid valves is applied;
- wherein the first and second inductors (L1, L2) in the first and second circuit component branches of the circuit arrangement and the extinguishing diode (D1) in the third circuit component branch of the circuit arrangement are connected in parallel with one another;
- the first and second inductors (L1, L2) are connected to a supply voltage of the circuit arrangement at a first common circuit node via a first and a second resistor (R1, R2) in the first and second circuit component branches of the circuit arrangement and the extinguishing diode (D1) in the third circuit component branch of the circuit arrangement, and the first and second inductors (L1, L2) and the extinguishing diode (D1) are connected to a first terminal of the switch (S0) at a second common circuit node at an intermediate potential between the supply voltage and a ground potential of the circuit arrangement;
- the cathode of the extinguishing diode (D1) is connected to the supply voltage, and the anode of the extinguishing diode (D1) is connected to the intermediate potential; and
- the switch (SO) in the fourth circuit component branch is connected in series with the parallel circuit of the first, second and third circuit component branches between the intermediate potential and the ground potential, and said switch (SO) switches simultaneously the two backup solenoid valves in the redundant operating mode.

2. The circuit arrangement as claimed in claim 1, wherein the first circuit component branch containing the first inductor (L1) contains the first resistor (R1) which forms, with the first inductor (L1), a first series circuit (L1/R1) in the first circuit component branch, and the second circuit component branch containing the second inductor (L2) contains the second resistor (R2) which forms, with the second inductor (L2), a second series circuit (L2/R2) in the second circuit component branch.

3. The circuit arrangement as claimed in claim 2, wherein a feedback line for feeding back a state of the circuit arrangement is respectively provided in the first series circuit (L1/R1), between the first inductor (L1) and the first resistor (R1), and in the second series circuit (L2/R2), between the second inductor (L2) and the second resistor (R2), and a control device senses a fault state of the circuit arrangement by reference to a fed-back state.

4. A circuit arrangement for switching two backup valves in a rear axle module of an electronic brake system of a utility vehicle with a redundant pneumatic brake system, having:
- a first backup solenoid valve in the redundant pneumatic brake system with a first inductor (L1) in a first circuit component branch of the circuit arrangement;
- a second backup solenoid valve in the redundant pneumatic brake system with a second inductor (L2) in the first circuit component branch of the circuit arrangement;
- an extinguishing diode (D1) for the first and second backup solenoid valves in a second circuit component branch of the circuit arrangement for a slow discharge of the first and second backup solenoid valves when the first and second backup solenoid valves are opened in a redundant operating mode in order to control a pneumatic brake pressure when the electronic brake system fails; and
- a switch (SO) in a third circuit component branch of the circuit arrangement by means of which pulse width modulation is applied in order to control the magnetic fields of the first and second inductors (L1, L2) of the first and second backup solenoid valves;
- wherein the first and second inductors (L1, L2) in the first circuit component branch of the circuit arrangement are connected in series with one another, and the extinguishing diode (D1) in the second circuit component branch of the circuit arrangement is connected in parallel with the series circuit of the first and second inductors (L1, L2) in the first circuit component branch of the circuit arrangement;
- the first inductor (L1) is connected to a supply voltage of the circuit arrangement at a first common circuit node via a resistor (R1) in the first circuit component branch of the circuit arrangement and the extinguishing diode (D1) in the second circuit component branch of the circuit arrangement, and the second inductor (L2) and the extinguishing diode (D1) are connected to a first terminal of the switch (S0) at a second common circuit node at an intermediate potential between the supply voltage and a ground potential of the circuit arrangement;
- the cathode of the extinguishing diode (D1) is connected to the supply voltage, and the anode of the extinguishing diode (D1) is connected to the intermediate potential; and
- the switch (S0) in the third circuit component branch is connected in series with the parallel circuit of the first and second circuit component branches between the intermediate potential and the ground potential, and said switch (SO) switches the two backup solenoid valves simultaneously in the redundant operating mode.

5. The circuit arrangement as claimed in claim 4, wherein the first circuit component branch containing the series circuit of the first and second inductors (L1, L2) of the two backup solenoid valves contains the resistor (R1) which in turn forms a series circuit (R1, L1, L2) with the series circuit of the first and second inductors (L1, L2).

6. The circuit arrangement as claimed in claim 5, wherein a feedback line for feeding back a state of the circuit arrangement is respectively provided between the first inductor (L1) and the second inductor (L2) in the first parallel circuit component branch and between the first inductor (L1) and the resistor (R1) in the first parallel circuit component branch, and a control device senses a fault state of the circuit arrangement by reference to the fed-back state.

7. The circuit arrangement as claimed in one of the preceding claims, wherein the actuation of the switch (SO) for generating the common pulse width modulation is carried out via a pulse width modulation application line.

8. The circuit arrangement as claimed in one of the preceding claims, wherein the switch (SO) is a rapidly switching field effect transistor.

9. The circuit arrangement as claimed in one of the preceding claims, wherein a terminal of the switch (SO) is connected to the ground potential.

10. The circuit arrangement as claimed in one of the preceding claims, wherein the pulse width modulation which is applied to the first switch (SO) clocks the circuit arrangement with a frequency between 1 and 10 kHz.

## Revendications

1. Montage pour la commutation de deux vannes de sécurité dans un module d'essieu arrière d'un système de freinage électronique dans un véhicule utilitaire à un système de freinage pneumatique redondant, comprenant :
- une première vanne à solénoïde de sécurité dans ledit système de freinage pneumatique redondant, à une première résistance inductive (L1) dans un premier circuit partiel du montage ;
- une deuxième vanne à solénoïde de sécurité dans ledit système de freinage pneumatique redondant, à une deuxième résistance inductive (L2) dans un deuxième circuit partiel du montage ;
- une diode d'amortissement (D1) pour lesdites première et deuxième vannes à solénoïde de sécurité dans un troisième circuit partiel du montage pour un amortissement lente desdites première et deuxième vannes à solénoïde de sécurité, quand lesdites première et deuxième vannes à solénoïde de sécurité sont ouvertes dans un mode de service de redondance au cas de défaillance du système de freinage électronique pour le réglage d'une pression pneumatique de freinage ; et
- un commutateur (SO) dans un quatrième circuit partiel du montage, moyennant lequel se règle une modulation d'impulsions en largeur pour la commande des champs magnétiques desdites première et deuxième résistances inductives (L1, L2) desdites première et deuxième vannes à solénoïde de sécurité ;
- dans lequel lesdites première et deuxième résistances inductives (L1, L2) dans lesdits premier et deuxième circuits partiels du montage et ladite diode d'amortissement (D1) dans ledit troisième circuit partiel du montage sont couplées l'une en parallèle à l'autre ;
- dans lequel lesdites première et deuxième résistances inductives (L1, L2) sont raccordées, via une première et une deuxième résistance (R1, R2) dans ledit premier circuit partiel et ledit deuxième circuit partiel du montage et ladite diode d'amortissement (D1) dans ledit troisième circuit partiel du montage est raccordée à un premier point nodal commun à une tension d'alimentation du montage, pendant que lesdites première et deuxième résistances inductives (L1, L2) et ladite diode d'amortissement (D1) sont raccordées à un deuxième point nodal commun de circuit à un potentiel intermédiaire entre la tension d'alimentation et un potentiel de masse du montage moyennant une première connexion dudit commutateur (S0) ;
- dans lequel la cathode de ladite diode d'amortissement (D1) est raccordée à la tension d'alimentation, pendant que l'anode de ladite diode d'amortissement (D1) est raccordée audit potentiel intermédiaire ; et
- dans lequel ledit commutateur (S0) dans ledit quatrième circuit partiel du montage est couplé en série relativement audit montage en parallèle desdits premier, deuxième et troisième circuits partiels de montage entre ledit potentiel intermédiaire et le potentiel de masse, et commute lesdites deux vannes à solénoïde de sécurité en même temps en mode de service à redondance.

2. Montage selon la revendication 1, dans lequel ledit premier circuit partiel, qui comprend ladite première résistance inductive (L1), renferme ladite première résistance (R1), qui coopère avec ladite première résistance inductive (L1) à constituer un premier montage (L1/R1) en série dans ledit premier circuit partiel, et ledit deuxième circuit partiel, qui comprend ladite deuxième résistance inductive (L2), renferme ladite deuxième résistance (R2), qui coopère avec ladite deuxième résistance inductive (L2) à constituer un deuxième montage (L2/R2) en série dans ledit deuxième circuit partiel.

3. Montage selon la revendication 2, dans lequel une ligne respective de signalisation en retour pour l'information en retour d'un état du montage est disposée dans ledit premier circuit en série (L1/R1) entre ladite première résistance inductive (L1) et ladite première résistance (R1) et dans ledit circuit en série (L2/R2) entre ladite deuxième résistance inductive (L2) et ladite deuxième résistance (R2), et dans lequel un dispositif de commande détecte un état de défaut du montage sur la base de l'état signalé en retour.

4. Montage pour la commutation de deux vannes de sécurité dans un module d'essieu arrière d'un système de freinage électronique dans un véhicule utilitaire à un système de freinage pneumatique redondant, comprenant :
- une première vanne à solénoïde de sécurité dans ledit système de freinage pneumatique redondant, à une première résistance inductive (L1) dans un premier circuit partiel du montage ;
- une deuxième vanne à solénoïde de sécurité dans ledit système de freinage pneumatique redondant, à une deuxième résistance inductive (L2) dans ledit premier circuit partiel du montage ;
- une diode d'amortissement (D1) pour lesdites première et deuxième vannes à solénoïde de sécurité dans un deuxième circuit partiel du montage pour un amortissement lente desdites première et deuxième vannes à solénoïde de sécurité, quand lesdites première et deuxième vannes à solénoïde de sécurité sont ouvertes dans un mode de service de redondance au cas de défaillance du système de freinage électronique pour le réglage d'une pression pneumatique de freinage ; et
- un commutateur (SO) dans un troisième circuit partiel du montage, moyennant lequel se règle une modulation d'impulsions en largeur pour la commande des champs magnétiques desdites première et deuxième résistances inductives (L1, L2) desdites première et deuxième vannes à solénoïde de sécurité ;
- dans lequel lesdites première et deuxième résistances inductives (L1, L2) dans ledit premier circuit partiel du montage et ladite diode d'amortissement (D1) dans ledit troisième circuit partiel du montage sont couplées l'une en parallèle à l'autre et ladite diode d'amortissement (D1) dans ledit deuxième circuit partiel du montage est couplée en parallèle audit circuit en série desdites première et deuxième résistances inductives (L1, L2) dans ledit premier circuit partiel du montage ;
- dans lequel ladite première résistance inductive (L1) est raccordée via une résistance (R1) dans ledit premier circuit partiel du montage à un premier point nodal commun à une tension d'alimentation du montage, pendant que ladite deuxième résistance inductive (L2) et ladite diode d'amortissement (D1) sont raccordées à un deuxième point nodal commun de circuit à un potentiel intermédiaire entre la tension d'alimentation et un potentiel de masse du montage moyennant une première connexion dudit commutateur (SO) ;
- dans lequel la cathode de ladite diode d'amortissement (D1) est raccordée à la tension d'alimentation, pendant que l'anode de ladite diode d'amortissement (D1) est raccordée audit potentiel intermédiaire ; et
- dans lequel ledit commutateur (S0) dans ledit troisième circuit partiel du montage est couplé en série relativement audit montage en parallèle desdits premier et deuxième circuits partiels de montage entre ledit potentiel intermédiaire et le potentiel de masse, et commute lesdites deux vannes à solénoïde de sécurité en même temps en mode de service à redondance.

5. Montage selon la revendication 4, dans lequel ledit premier circuit partiel du montage, qui contient le montage en série desdites première et deuxième résistances inductives (L1, L2) desdites deux vannes à solénoïde de sécurité, renferme ladite résistance (R1), qui, à son tour, coopère avec ledit montage en série desdites première et deuxième résistances inductives (L1, L2) à constituer un montage en série (R1, L1, L2).

6. Montage selon la revendication 5, dans lequel une ligne respective de signalisation en retour pour l'information en retour d'un état du montage est disposée dans ledit premier circuit en série (L1/R1) entre ladite première résistance inductive (L1) et ladite deuxième résistance inductive (L2) dans ledit premier circuit partiel en parallèle et entre ladite première résistance inductive (L1) et ladite résistance (R2), et dans lequel un dispositif de commande détecte un état de défaut du montage sur la base de l'état signalé en retour.

7. Montage selon une quelconque des revendications précédentes, dans lequel la commande dudit commutateur (SO) se réalise via une ligne de réglage de modulation d'impulsions en largeur afin d'engendrer la modulation commune d'impulsions en largeur.

8. Montage selon une quelconque des revendications précédentes, dans lequel ledit commutateur (SO) est un transistor à effet de champ à grande vitesse de commutation.

9. Montage selon une quelconque des revendications précédentes, dans lequel un raccord dudit commutateur (S0) est raccordé audit potentiel de masse.

10. Montage selon une quelconque des revendications précédentes, dans lequel la modulation d'impulsions en largeur, qui est réglée audit premier commutateur (S0), synchronise le montage à une fréquence entre 1 et 10 kHz.
